# EUROPEAN PATENT APPLICATION

(11) **EP 2 120 254 A2**
(43) Date of publication of application: **18.11.2009**
(21) Application number: 09251294.6
(22) Date of filing: 12.05.2009
(51) Int. Cl.: H01J 37/32, H05H 1/24

(54) **Plasma processing apparatus**

(30) Priority: 13.05.2008 JP 2008126231
(71) Applicant: NGK Insulators, Ltd., Aichi Pref. 467-8530 (JP)
(72) Inventor: Masuda, Masaaki, Nagoya City Aichi-ken 467-8530 (JP); Miyairi, Yukio, Nagoya City Aichi-ken 467-8530 (JP); Takahashi, Michio, Nagoya City Aichi-ken 467-8530 (JP)
(74) Representative: Paget, Hugh Charles Edward

(57) **Abstract**

A plasma processing apparatus includes a main body that has an inlet for a purification target gas and an outlet for a purified gas, an insulator honeycomb that includes a plurality of cells that are partitioned by a partition wall and serve as gas passages, a conductor honeycomb that is disposed to be able to transmit heat to the insulator honeycomb, a discharge electrode that is disposed opposite to the conductor honeycomb and forms a pair of electrodes with the conductor honeycomb, and a pulse power supply that applies a pulse voltage between the pair of electrodes, the insulator honeycomb, the conductor honeycomb, and the discharge electrode being disposed in an inner space of the main body. The plasma processing apparatus generates plasma by applying a pulse voltage to promote purification of the purification target gas in the insulator honeycomb by utilizing heat generated by plasma.

## Description

### BACKGROUND OF THE INVENTION

Field of the Invention

The present invention relates to a plasma processing apparatus that effectively purifies toxic substances (particularly hydrocarbons (HC) that are produced in large quantities) discharged from an internal combustion engine during startup (cold start).

Description of Related Art

In recent years, the exhaust emission regulations have been stringent in each country along with a growing environmental movement. Therefore, engines have been improved to reduce the emission of toxic substances such as hydrocarbons (HC), carbon monoxide (CO), and nitrogen oxide (NOx), and a honeycomb-structured catalytic converter has been widely used to purify exhaust gas discharged from an engine and the like. Such a catalytic converter is produced by coating the surface of a partition wall of a honeycomb-structured carrier (honeycomb carrier) with a catalyst layer in which a catalyst (e.g., precious metal) is dispersed in and supported on a heat-resistant inorganic oxide having a large specific surface area (e.g., alumina), the honeycomb-structured carrier including a porous partition wall that is disposed so that a plurality of cells are formed between the end faces of the honeycomb-structured carrier.

In order to promote purification of exhaust gas, it is necessary to increase the temperature of the metal catalyst of the catalytic converter so that the metal catalyst is activated. The metal catalyst is activated by high-temperature exhaust gas after a given period of time has elapsed after starting an engine. However, the catalyst is not sufficiently activated immediately after starting an engine due to a low exhaust gas temperature so that toxic substances pass through the catalytic converter without being purified.

Therefore, it is important to promptly increase the temperature of the catalyst to the activation temperature. As a means to promptly increase the temperature of the catalyst to the activation temperature, attempts have been made such as reducing the heat capacity of the honeycomb carrier, increasing the cell density of the honeycomb carrier to improve heat transmission, or heating gas using an electrical heating means.

JP-A-8-218857 discloses an electrical heating-type catalyst that is formed of a honeycomb structure having a circular cross section and provided with exhaust passages and has a slit. The electrical heating-type catalyst disclosed in JP-A-8-218857 exhibits an improved exhaust gas purification capability since the temperature distribution of the catalyst carrier can be made uniform.

JP-A-2008-45435 discloses an electrical heating-type catalyst apparatus that can efficiently heat the catalyst within a short time without requiring a complex configuration and exhibits an improved exhaust gas purification capability. According to JP-A-2008-45435, power is supplied to the catalyst carrier formed in the shape of a sheet to generate heat so that the exhaust gas purification catalyst is heated. The catalyst apparatus has a narrow portion in which the width in the power supply path direction is partially reduced.

In order to reduce automotive exhaust gas, it is desirable that catalytic ignition occur at a relatively low temperature. JP-A-2005-342714 discloses a catalytic ignition promoter that contains at least one activation metal for reducing the catalytic ignition activation energy. The catalytic ignition promoter is easily prepared from a number of metal supply sources including a spent catalyst and is activated promptly to ensure effective catalytic ignition.

JP-T-2007-505265 discloses a method of operating a catalyst for treating exhaust gas from an internal combustion engine, the catalyst including catalytically active precious metals and storage components for storing hydrocarbons.

JP-A-2007-38121 discloses a gas purification system that effectively decomposes hydrocarbons during startup of an engine by utilizing reactive species generated by plasma without using a catalyst of which the purification function changes depending on the temperature. JP-A-2007-38121 discloses an embodiment in which a discharge reaction section that generates plasma includes a rod-like conductor electrode and a planar common electrode. This makes it possible to initiate a high-energy discharge at a low applied voltage so that gas can be effectively purified at a low temperature at which catalytic activation does not occur.

JP-T-2004-160297 discloses an exhaust gas purification apparatus that includes a catalyst that purifies exhaust gas that is discharged from an internal combustion engine and contains NOₓ and HC, and a plasma generation device that generates plasma. NO contained in exhaust gas is oxidized into active NO₂ by utilizing plasma, and NO₂ is reduced and purified by utilizing the catalyst.

JP-A-5-98956 discloses an exhaust gas purification system that includes an exhaust gas purification catalyst, a corona discharge device, and an air supply device provided on the upstream side of the corona discharge device. The exhaust gas purification system disclosed in JP-A-5-98956 causes a corona discharge in a state in which exhaust gas has a high hydrocarbon concentration and the temperature of the catalyst has not reached the activating temperature immediately after starting an engine to obtain a sufficiently high hydrocarbon conversion rate.

### SUMMARY OF THE INVENTION

According to JP-A-8-218857 and JP-A-2008-45435, since the temperature increase rate is low when a small amount of power is supplied, the temperature of the catalyst supported on the heater does not reach the ignition temperature within a short time. As a result, most of the hydrocarbons (HC) produced in large quantities during startup (cold start) of an engine are not purified. The temperature of the catalyst reaches the ignition temperature within a short time by supplying a large amount of power. However, since a large-capacity battery, a special cable, and a control device are required, the system cost increases.

It is difficult to control the temperature using the ignition promoter disclosed in JP-A-2005-342714 so that the promoting effect decreases due to deterioration. As a result, hydrocarbons (HC) are not sufficiently purified. The hydrocarbon storage agent disclosed in JP-T-2007-505265 cannot sufficiently store hydrocarbons produced in large quantities. Since the storage capability decreases along with a deterioration in the storage agent, hydrocarbons (HC) are not sufficiently purified. Specifically, the effects achieved by these means are limited.

According to JP-A-2007-38121, gas is purified by utilizing plasma without using a catalyst. However, a large amount of power is required since a catalyst is not used. JP-T-2004-160297 and JP-A-5-98956 utilize plasma when the temperature of the catalyst is low. However, since gas is reduced and purified by utilizing the catalyst, the purification efficiency at a low temperature is insufficient, and power is required to generate plasma until the temperature of the catalyst increases. Therefore, power is not efficiently utilized.

An object of the present invention is to provide a plasma processing apparatus that utilizes a honeycomb structure and can effectively purify toxic substances (particularly hydrocarbons) discharged from an internal combustion engine during startup.

The inventors of the present invention found that heat generated by plasma can be transmitted to an insulator honeycomb to promote a reaction so that a purification target gas can be efficiently purified by disposing an insulator honeycomb, a conductor honeycomb that is disposed to be able to transmit heat to the insulator honeycomb, and a discharge electrode that forms a pair of electrodes with the conductor honeycomb in the inner space of a main body. According to the present invention, the following plasma processing apparatus is provided.

[1] A plasma processing apparatus comprising a main body that has an inlet for a purification target gas and an outlet for a purified gas, an insulator honeycomb that includes a plurality of cells that are partitioned by a partition wall and serve as gas passages and purifies the purification target gas, a catalyst being supported on the partition wall, a conductor honeycomb that is disposed to be able to transmit heat to the insulator honeycomb and includes a plurality of cells that are partitioned by a partition wall and serve as gas passages, a discharge electrode that is disposed opposite to the conductor honeycomb and forms a pair of electrodes with the conductor honeycomb, and a pulse power supply that applies a pulse voltage between the pair of electrodes to generate plasma between the pair of electrodes, the insulator honeycomb, the conductor honeycomb, and the discharge electrode being disposed in an inner space of the main body.

[2] The plasma processing apparatus according to [1], wherein the discharge electrode, the conductor honeycomb, and the insulator honeycomb are disposed in this order from the inlet to the outlet of the main body.

[3] The plasma processing apparatus according to [1] or [2], wherein the conductor honeycomb is disposed to physically come in contact with the insulator honeycomb.

[4] The plasma processing apparatus according to any one of [1] to [3], wherein the conductor honeycomb is disposed to come in contact with a purification target gas inlet side of the insulator honeycomb.

[5] The plasma processing apparatus according to any one of [1] to [3], wherein the conductor honeycomb is embedded in part of a purification target gas inlet side of the insulator honeycomb.

[6] The plasma processing apparatus according to any one of [1] to [5], wherein the insulator honeycomb includes an insulating ceramic.

[7] The plasma processing apparatus according to [6], wherein the insulator honeycomb includes cordierite.

[8] The plasma processing apparatus according to any one of [1] to [7], wherein the conductor honeycomb includes a conductive ceramic.

[9] The plasma processing apparatus according to [8], wherein the conductive ceramic includes silicon carbide.

[10] The plasma processing apparatus according to any one of [1] to [9], wherein a catalyst is supported on the partition wall of the conductor honeycomb.

[11] The plasma processing apparatus according to any one of [1] to [10], wherein a discharge end of the discharge electrode is a needle-like electrode or a rod-like electrode.

[12] The plasma processing apparatus according to any one of [1] to [11], wherein a pulse half-width of the pulse power supply for generating plasma can be controlled to 1 µs or less.

Since the plasma processing apparatus includes the conductor honeycomb and the discharge electrode that forms a pair of electrodes with the conductor honeycomb, heat generated by plasma that is generated between the pair of electrodes can be transmitted to the insulator honeycomb to promote a reaction so that the purification target gas can be efficiently purified. Specifically, since the conductor honeycomb forms part of the honeycomb structure that purifies the purification target gas, the temperature of the conductor honeycomb can be increased by applying a pulse voltage within a short time using only a small amount of power, and the catalyst supported on the insulator honeycomb can be activated by utilizing heat generated by the conductor honeycomb so that purification of the purification target gas can be promoted. Specifically, since power used to generate plasma can also be used to increase the temperature of the catalyst, the catalyst can be activated within a short time so that exhaust gas can be purified using only a small amount of power. Therefore, toxic substances (particularly hydrocarbons (HC) that are produced in large quantities) discharged from an internal combustion engine during startup (cold start) can be effectively purified.

### BRIEF DESCRIPTION OF THE DRAWINGS

FIG. 1 is a schematic cross-sectional view showing a plasma processing apparatus (reactor 1) according to a first embodiment of the present invention.

FIG. 2 is a schematic view showing a power supply line configuration of a plasma processing apparatus (reactor 1) according to a first embodiment of the present invention.

FIG. 3 is a schematic cross-sectional view showing a plasma processing apparatus (reactor 2) according to a second embodiment of the present invention.

FIG. 4 is a schematic cross-sectional view showing a plasma processing apparatus (reactor 3) according to a third embodiment of the present invention.

FIG. 5 is a schematic view showing a power supply line configuration of a plasma processing apparatus (reactor 3) according to a third embodiment of the present invention.

FIG. 6 is a schematic cross-sectional view showing a plasma processing apparatus (reactor 4) according to a fourth embodiment of the present invention.

FIG. 7 is a schematic view showing a power supply line configuration of a plasma processing apparatus (reactor 4) according to a fourth embodiment of the present invention.

FIG. 8 is a schematic view showing a system used to evaluate the performance of a plasma processing apparatus in the examples

### DESCRIPTION OF PREFERRED EMBODIMENTS

Embodiments of the present invention are described below with reference to the drawings. Note that the present invention is not limited to the following embodiments. Various modifications and improvements may be made without departing from the scope of the present invention.

(First embodiment)

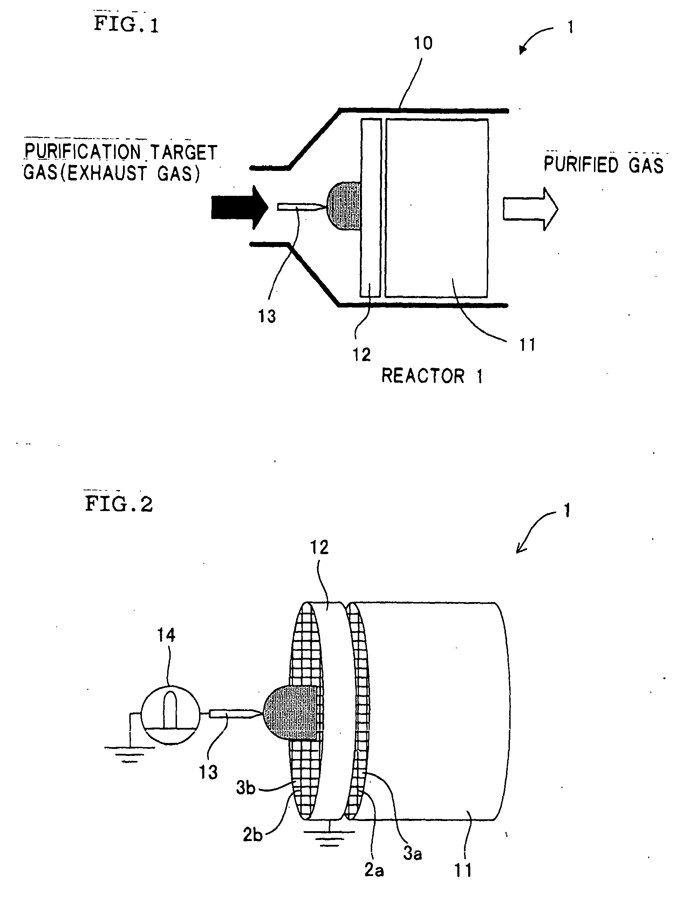

FIGS. 1 and 2 show a plasma processing apparatus 1 (reactor 1) according to a first embodiment of the present invention. FIG. 1 is a schematic cross-sectional view showing the plasma processing apparatus 1 according to the first embodiment. FIG. 2 is a schematic view showing a plasma generation power supply line configuration. The plasma processing apparatus 1 according to the present invention includes a main body 10 that has an inlet for a purification target gas and an outlet for a purified gas, an insulator honeycomb 11 that includes a plurality of cells 3a that are partitioned by a partition wall 2a and serve as gas passages, a conductor honeycomb 12 that is disposed to be able to transmit heat to the insulator honeycomb 11, a discharge electrode 13 that is disposed opposite to the conductor honeycomb 12 and forms a pair of electrodes with the conductor honeycomb 12, and a pulse power supply 14 that applies a pulse voltage between the pair of electrodes, the insulator honeycomb 11, the conductor honeycomb 12, and the discharge electrode 13 being disposed in an inner space of the main body 10.

The main body 10 is a tubular structure in which an inlet for a purification target gas and an outlet for a purified gas are formed. It is necessary for the main body 10 to be hollow so that gas can pass through. The shape of the main body 10 is not particularly limited as long as the main body 10 is hollow. For example, the main body 10 may have a cylindrical shape, a rectangular cylindrical shape, or the like. The maximum inner diameter of the main body 10 is not particularly limited. The size of the main body 10 may be appropriately determined corresponding to the application of the plasma processing apparatus.

The material for the main body 10 is not particularly limited. It is preferable to form the housing area of the main body 10 using a metal (e.g., stainless steel) having excellent workability. It is preferable that the electrode installation section and the like inside the housing be formed of an insulating material from the viewpoint of preventing a short circuit.

The conductor honeycomb 12 is formed so that a purification target gas (e.g., exhaust gas) can pass through the conductor honeycomb 12 from one end to the other end. In this embodiment, the conductor honeycomb 12 is a cylindrical honeycomb structure. Note that the shape of the conductor honeycomb 12 is not limited thereto. The conductor honeycomb 12 may be a honeycomb structure of another shape such as a quadrangular prism. As the material for the conductor honeycomb 12, it is preferable to use a ceramic that exhibits excellent heat resistance taking a usage environment into consideration. It is particularly preferable to use silicon carbide that also exhibits heat transfer properties. Note that the entire conductor honeycomb 12 need not necessarily be formed of silicon carbide. In the present invention, it is preferable that the conductor honeycomb 12 be formed of a conductive ceramic that contains silicon carbide. It is preferable that the conductive ceramic have a volume resistivity of 1×10⁻² Ωcm to 1×10⁶ Ωcm and a thermal conductivity at room temperature of 10 to 300 W/mK. Note that the volume resistivity and the thermal conductivity are not limited thereto.

The structure of the conductor honeycomb 12 is not particularly limited as long as the conductor honeycomb 12 is a honeycomb structure in which a plurality of cells 3b that serve as gas passages are partitioned by the partition wall 2b. For example, the shape of the cells may be appropriately selected from a circle, an ellipse, a triangle, a quadrangle, another polygonal shape, and the like corresponding to the shape of the cells of the insulator honeycomb. It is more preferable that the cells of the conductor honeycomb 12 have the same shape as that of the cells of the insulator honeycomb 11. The cell density (i.e., the number of cells per unit cross-sectional area) of the conductor honeycomb 12 is not particularly limited, but may be appropriately designed corresponding to the objective. It is preferable that the conductor honeycomb 12 have the same cell density as that of the insulator honeycomb 11. In this case, it is preferable that the conductor honeycomb 12 have a cell density of 25 to 2000 cells/in² (4 to 320 cells/cm²). If the cell density of the conductor honeycomb 12 is less than 25 cells/in², the strength of the partition wall 2b may decrease so that the strength and the effective geometric surface area (GSA) of the conductor honeycomb 11 may become insufficient. If the cell density of the conductor honeycomb 12 is more than 2000 cells/in², a pressure loss that occurs when exhaust gas flows may increase.

It is preferable that the length (length in the gas flow direction) of the conductor honeycomb 12 be 5 to 40% (=length of conductor honeycomb 12/length of insulator honeycomb 11), and more preferably 10 to 30% of the length (length in the gas flow direction) of the insulator honeycomb 11. If the length of the conductor honeycomb 12 is less than 5% of the length of the insulator honeycomb 11, the amount of heat transferred from the conductor honeycomb 12 to the insulator honeycomb 11 may decrease. As a result, an increase in temperature of the insulator honeycomb 11 may be insufficient so that the catalytic ignition effect may decrease. If the length of the conductor honeycomb 12 is more than 40% of the length of the insulator honeycomb 11, the volume ratio of the conductor honeycomb 12 to the insulator honeycomb 11 increases so that the exhaust gas purification function of the insulator honeycomb 11 may deteriorate.

It is preferable that the conductor honeycomb 12 have an electrical resistance of 2 Ω or less, and more preferably 0.3 Ω or less at a temperature of 180°C and an applied voltage of 3.5 V, from the viewpoint of ensuring conductivity. In order to achieve such an electrical resistance, it is preferable to use silicon carbide as the conductive ceramic, and mix metal silicon with silicon carbide or form a silicon carbide-metal silicon composite, for example. The term "electrical resistance" used herein refers to a value determined by measuring the electrical resistance of a rectangular parallelepiped sample (length: 3.3 cm, cross-sectional area: 1.1 cm² (cross-sectional area of the cross section perpendicular to the gas flow direction)) obtained by cutting the honeycomb electrode along the gas flow direction (cell formation direction) by a constant-current four-terminal method using a direct-current power supply at a temperature of 180°C and a voltage terminal distance of 2.3 cm.

It is preferable that a catalyst be supported on the conductor honeycomb 12. This ensures that the conductor honeycomb 12 exhibits an exhaust gas purification function (i.e., an efficient exhaust gas purification function due to a complex reaction of plasma and the catalyst). A metal catalyst supported on the conductor honeycomb 12 includes at least one element selected from the group consisting of a precious metal (i.e., platinum, rhodium, palladium, ruthenium, indium, silver, and gold), aluminum, nickel, zirconium, titanium, cerium, cobalt, manganese, zinc, copper, tin, iron, niobium, magnesium, lanthanum, samarium, bismuth, and barium. These elements may be in the form of an oxide or a compound other than an oxide. A carrier that supports the metal catalyst preferably includes at least one element selected from the group consisting of alumina, ceria, and zirconia.

The amount of catalyst (metal catalyst + carrier) supported on the conductor honeycomb 12 is preferably 10 to 400 g/l. When using a precious metal as the metal catalyst, the amount of catalyst supported on the conductor honeycomb 12 is more preferably 0.1 to 5 g/l. If the amount of catalyst (metal catalyst + carrier) supported on the conductor honeycomb 12 is less than 10 g/l, the catalyst may not exhibit a catalytic effect. If the amount of catalyst supported on the conductor honeycomb 12 is more than 400 g/l, a pressure loss and the production cost may increase.

The discharge electrode 13 is described below. The discharge electrode 13 is formed as a needle-like electrode. The term "linear electrode" used herein refers to a rod-like electrode. Examples of the linear electrode include a needle-like electrode and the like in addition to a rod-like electrode. The term "rod-like" refers to a linear cylindrical shape of which the outer diameter is uniform along the longitudinal direction. The term "needle-like" refers to a linear shape having a sharp end. The linear electrode is not necessarily limited to a linear shape such as that of a rod-like electrode and a needle-like electrode. For example, the linear electrode may be bent such as in the shape of the letter "L". It suffices that at least one linear electrode be disposed (i.e., a plurality of linear electrodes may be disposed).

It is preferable that the linear electrode be formed of a highly conductive material (e.g., metal, alloy, or conductive ceramic) from the viewpoint of ensuring conductivity. Examples of a highly conductive metal include stainless steel, nickel, copper, aluminum, iron, and the like. Examples of a highly conductive alloy include an aluminum-copper alloy, a titanium alloy, Inconel (registered trademark), and the like. Examples of a conductive ceramic include silicon carbide and the like. Examples of other materials include carbon and the like.

The length of the linear electrode is preferably 3 to 50 mm, and more preferably 5 to 30 mm, in order to reduce the size of the plasma processing apparatus 1. If the length of the linear electrode is less than 3 mm, handling of the linear electrode may become unstable when producing the plasma processing apparatus 1 so that it may be difficult to secure the linear electrode. If the length of the linear electrode is more than 50 mm, the linear electrode may be curved due to contact with the flow of a purification target gas. The outer diameter of the linear electrode is preferably 0.1 to 5 mm, and more preferably 0.5 to 3 mm. If the outer diameter of the linear electrode is less than 0.1 mm, the linear electrode may be curved due to contact with the flow of a purification target gas. As a result, a plasma discharge may become unstable. If the outer diameter of the linear electrode is more than 5 mm, it may be difficult to control a plasma discharge.

It is preferable that the linear electrode (discharge electrode 13) be disposed so that the electrode-to-electrode distance between the linear electrode and the conductor honeycomb 12 is 1 to 30 mm, and more preferably 5 to 10 mm. If the electrode-to-electrode distance is less than 1 mm, a short circuit may easily occur due to electric field concentration. If the electrode-to-electrode distance is more than 30 mm, a plasma discharge may become unstable so that the plasma generation efficiency may decrease.

The pulse power supply 14 is described below. The term "pulse power supply" refers to a power supply that applies a pulse voltage between a pair of electrodes. A power supply that can periodically apply a voltage may be used as the pulse power supply 14. It is preferable to use a power supply that can supply (a) a pulse waveform having a peak voltage of 1 kV or more and a pulse number per second of 1 or more, (b) an AC voltage waveform having a peak voltage of 1 kV or more and a frequency of 1 or more, (c) a DC waveform having a voltage of 1 kV or more, or (d) a voltage waveform formed by superimposing these waveforms. It is more preferable to use a power supply having a peak voltage of 1 to 20 kV, and more preferably 5 to 10 kV. It is preferable that the pulse half-width of the pulse power supply 14 be controlled to 1 µs or less. Examples of such a power supply include a high-voltage pulse power supply that utilizes a static induction thyristor (SI thyristor) (manufactured by NGK Insulators, Ltd.) and the like.

The insulator honeycomb 11 is described below. The insulator honeycomb 11 has insulating properties and is formed in the shape of a culumn so that gas can pass through the insulator honeycomb 11 from one end to the other end. In this embodiment, the insulator honeycomb 11 is a cylindrical honeycomb structure. Note that the shape of the insulator honeycomb i is not limited thereto. The insulator honeycomb 11 may be a honeycomb structure of another shape such as a quadrangular prism. The insulator honeycomb main body is formed of an insulating material. It is preferable that the insulator honeycomb main body be formed of a ceramic (insulating ceramic). As the ceramic, alumina, zirconia, silicon nitride, aluminum nitride, sialon, mullite, silica, cordierite, or the like may be suitably used. These materials may be used either individually or in combination.

A catalyst is supported on the insulator honeycomb 11. A metal catalyst supported on the insulator honeycomb 11 is not particularly limited as long as exhaust gas can be purified. It is preferable that the metal catalyst include at least one element selected from precious metals such as platinum, rhodium, and palladium. These elements may be in the form of an oxide or a compound other than an oxide. A carrier that supports the metal catalyst preferably includes at least one element selected from the group consisting of alumina, ceria, and zirconia.

The amount of catalyst (metal catalyst + carrier) supported on the insulator honeycomb 11 is preferably 10 to 400 g/l. When using a precious metal as the metal catalyst, the amount of catalyst supported on the insulator honeycomb 11 is more preferably 0.1 to 5 g/l. If the amount of catalyst (metal catalyst + carrier) supported on the insulator honeycomb 11 is less than 10 g/l, the catalyst may not exhibit a catalytic effect. If the amount of catalyst supported on the insulator honeycomb 11 is more than 400 g/l, a pressure loss and the production cost may increase.

In the plasma processing apparatus 1 according to the present invention, the discharge electrode 13, the conductor honeycomb 12, and the insulator honeycomb 11 are disposed in the inner space of the main body 10 in this order from the inlet side to the outlet side. The discharge electrode 13 is formed as a linear electrode. The linear electrode is disposed opposite to the conductor honeycomb 12 so that plasma is generated between the linear electrode and the conductor honeycomb 12. The conductor honeycomb 12 is disposed to be able to transmit heat to the insulator honeycomb 11 so that heat generated by the conductor honeycomb 12 is transmitted to the insulator honeycomb 11 and serves as an ignition source for the catalyst supported on the insulator honeycomb 11. In the plasma processing apparatus 1 according to the first embodiment shown in FIG. 1, the conductor honeycomb 12 is disposed on the upstream side of the insulator honeycomb 11 at an interval from the insulator honeycomb 11. Since the conductor honeycomb 12 is disposed at an interval from the insulator honeycomb 11, active species and the like (that contribute to HC purification) generated by plasma are easily diffused in the insulator honeycomb 11 as compared with a plasma processing apparatus in which the conductor honeycomb 12 is in contact with the insulator honeycomb 11.

According to the above-described configuration, activation (ignition) of the catalyst supported on the insulator honeycomb 11 can be promoted using plasma generated by supplying only a small amount of power. Specifically, heat is generated by the conductor honeycomb 12 by generating plasma between the conductor honeycomb 12 and the linear electrode, and is transmitted to the insulator honeycomb 11 to activate the catalyst supported on the insulator honeycomb 11. As a result, a purification target gas (exhaust gas) can be efficiently purified and discharged as a purified gas. Specifically, since power used to generate plasma is also used to increase the temperature of the catalyst, the temperature of the catalyst can be increased within a short time using a small amount of power so that exhaust gas can be efficiently purified. Moreover, activation of the catalyst can be further promoted by utilizing the heat of an exhaust gas purification reaction generated by the conductor honeycomb 11 that supports the catalyst. As described above, toxic substances discharged during startup (cold start) of an engine can be purified instantaneously by utilizing the catalyst and plasma generated using a small amount of power. The plasma processing apparatus 1 is particularly effective to purify hydrocarbons (HC) that are produced in large quantities.

(Second embodiment)

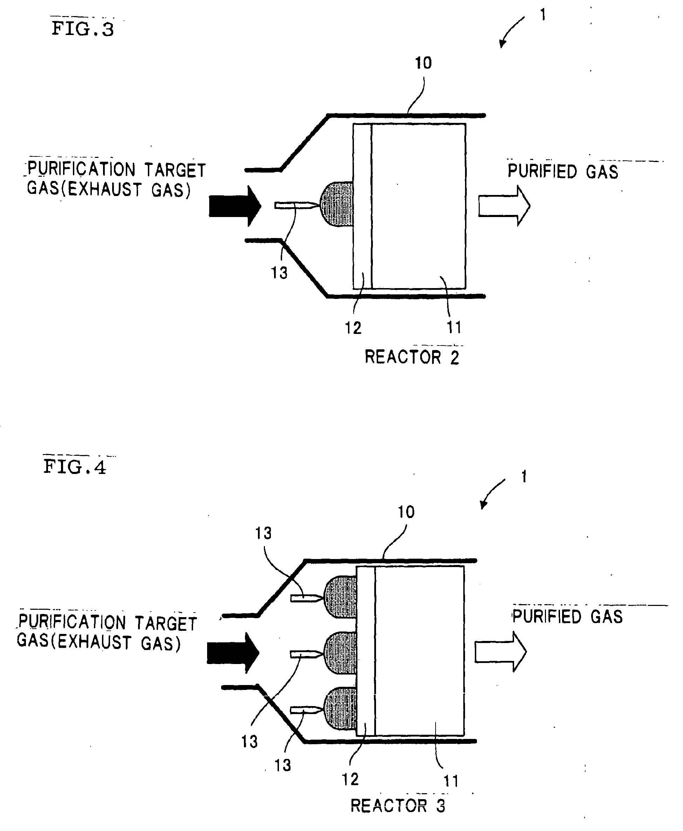

FIG. 3 shows a plasma processing apparatus 1 (reactor 2) according to a second embodiment of the present invention. As shown in FIG. 3, the conductor honeycomb 12 may be disposed to physically come in contact with the insulator honeycomb 11. In the second embodiment, the conductor honeycomb 12 is disposed to come in contact with the purification target gas inlet side of the insulator honeycomb 11. According to this configuration, heat generated by generating plasma between the linear electrode and the conductor honeycomb 12 can be directly transmitted to the insulator honeycomb 12 and used as an ignition source for the catalyst supported on the insulator honeycomb 11.

(Third embodiment)

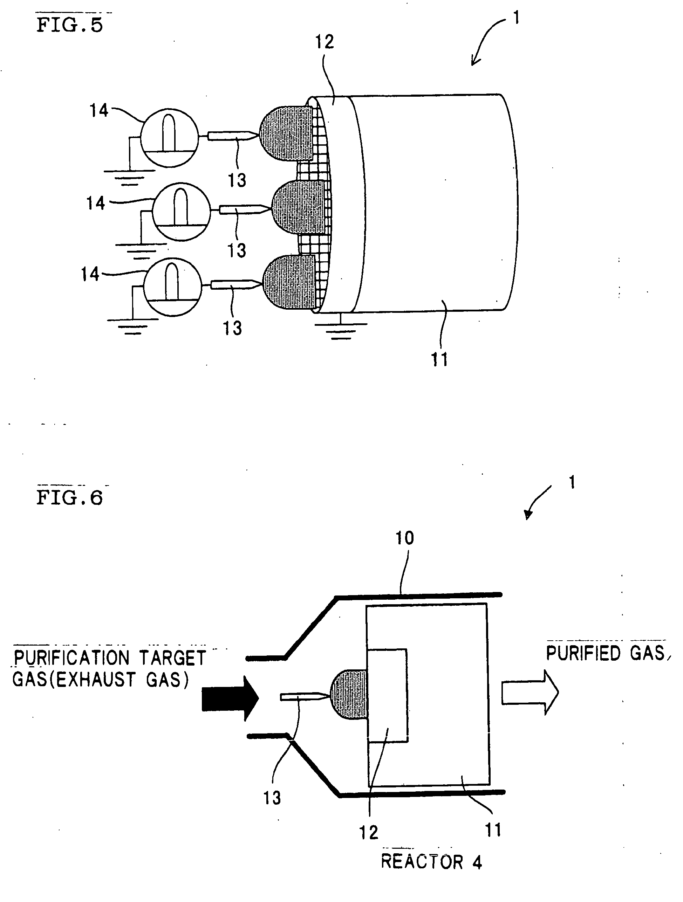

FIGS. 4 and 5 show a plasma processing apparatus 1 (reactor 3) according to a third embodiment of the present invention. As shown in FIGS. 4 and 5, the plasma processing apparatus 1 according to the third embodiment includes a plurality of discharge electrodes 13 and a plurality of pulse power supplies 14. The plasma generation area is increased by disposing a plurality of discharge electrodes 13 so that gas can be efficiently purified. Therefore, it is preferable to dispose a plurality of discharge electrodes 13.

(Fourth embodiment)

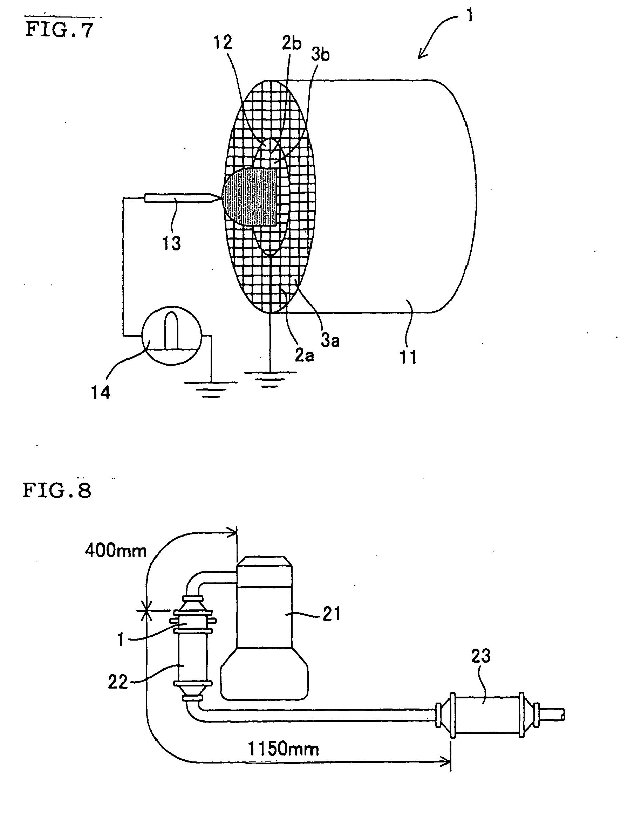

FIGS. 6 and 7 show a plasma processing apparatus 1 (reactor 4) according to a fourth embodiment of the present invention. In the plasma processing apparatus 1 according to the fourth embodiment, the conductor honeycomb 12 is disposed to physically come in contact with the insulator honeycomb 11, as shown in FIGS. 6 and 7. In the fourth embodiment, the conductor honeycomb is embedded in part of the purification target gas inlet side of the insulator honeycomb. According to this configuration, since heat generated by the conductor honeycomb can be easily transmitted to the insulator honeycomb, gas can be purified more efficiently.

When the conductor honeycomb 12 is embedded in part of the purification target gas inlet side of the insulator honeycomb 11 as in the fourth embodiment, it is preferable that the width (dimension in the direction perpendicular to the gas flow direction) of the conductor honeycomb 12 be 5 to 90% (=width of conductor honeycomb 12/width of insulator honeycomb 11), and more preferably 10 to 50% of the width (dimension in the direction perpendicular to the gas flow direction) of the insulator honeycomb 11. If the width of the conductor honeycomb 12 is less than 5% of the width of the insulator honeycomb 11, the amount of heat transferred from the conductor honeycomb 12 to the insulator honeycomb 11 may decrease. As a result, an increase in temperature of the insulator honeycomb 11 may be insufficient so that the catalytic ignition effect may decrease. If the width of the conductor honeycomb 12 is more than 90% of the width of the insulator honeycomb 11, the conductor honeycomb 12 that holds the insulator honeycomb 11 may exhibit an insufficient strength.

### EXAMPLES

The present invention is further described below by way of examples. Note that the present invention is not limited to the following examples.

(Conductor honeycomb main body)

As a conductor honeycomb, a honeycomb structure which was formed of silicon carbide (content: 75 mass%) and in which a plurality of cells 3b serving as gas passages were partitioned by a partition wall 2b was used. The honeycomb structure was obtained by cutting a silicon carbide diesel particulate filter ("SiC-DPF" manufactured by NGK Insulators, Ltd.) for trapping particulate matter contained in engine exhaust gas or the like.

Specifically, two honeycomb structures that differed in size were cut from the diesel particulate filter "SiC-DPF". One of the two honeycomb structures was a cylindrical honeycomb structure having a square cell shape, a cell density of 96 cells/cm², an outer diameter of 100 mm, and a length (length in the gas flow direction) of 30 mm. The other of the two honeycomb structures was a cylindrical honeycomb structure having a square cell shape, a cell density of 96 cells/cm², an outer diameter of 30 mm, and a length (length in the gas flow direction) of 30 mm. A rectangular parallelepiped sample (length: 3.3 cm, cross-sectional area: 12.3 cm² (cross-sectional area of the cross section perpendicular to the gas flow direction)) was obtained by cutting the diesel particulate filter "SiC-DPF" (manufactured by NGK Insulators, Ltd.). The electrical resistance of the sample measured by a constant-current four-terminal method using a direct-current power supply at a temperature of 180°C and a voltage terminal distance of 2.5 cm was 0.2 Ω. The thermal conductivity of the sample measured at 180°C was 100 W/mK. The thermal conductivity of the sample measured at room temperature was 10 W/mK.

(Insulator honeycomb main body)

A raw material (cordierite) was extruded using a metal die and then fired to obtain an insulator honeycomb. The insulator honeycomb was formed so that the length of the insulator honeycomb in the exhaust gas flow direction was 100 mm, the diameter of the end face was 100 mm, the cell density was 96 cells/cm², and the thickness of the partition wall 2a was 0.1 mm (dimensions after firing).

(Catalyst)

A catalyst was supported on the insulator honeycomb and the conductor honeycomb as follows. A γ-Al₂O₃ powder and a CeO₂ powder were mixed in a weight ratio of 70:30. Water and a small amount of nitric acid were added to the mixed powder. The mixture was wet-ground to prepare a carrier slurry. A washcoat layer was formed on each of the conductor honeycomb and the insulator honeycomb by a dipping method using the carrier slurry. The washcoat layer was dried and fired at 500°C so that each honeycomb was coated with γ-Al₂O₃ and CeO₂. The honeycomb was impregnated with a catalyst composition (aqueous solution of chloroplatinic acid and rhodium nitrate (Pt:Rh=5.1 (molar ratio))) for about 20 minutes so that the total amount of catalyst supported on the honeycomb was 1 g/l. The catalyst was supported on the insulator honeycombs of the examples and comparative examples. The presence or absence of catalyst supported on the conductor honeycomb is shown in Table 1.

(Discharge electrode)

As a discharge electrode, a rod-like product formed of a nickel alloy ("Inconel 600" manufactured by Nilaco Corporation) and having a length of 10 mm and an outer diameter of 0.5 mm was used. The conductor honeycomb was disposed so that the electrode-to-electrode distance between the conductor honeycomb and the discharge electrode (linear electrode) was 5 mm. In the plasma processing apparatus, the linear electrode was used as a positive electrode.

(Arrangement of conductor honeycomb and insulator honeycomb)

A reactor in which the distance between the conductor honeycomb and the insulator honeycomb was 5 mm was produced (Example 1: see FIG. 1). A reactor in which the conductor honeycomb was in contact with the insulator honeycomb was also produced (Examples 2, 3, 5, and 6 and Comparative Example 2: see FIG. 3 for Examples 2 and 5 and Comparative Example 2, and see FIG 4 for Examples 3 and 6). A reactor in which the conductor honeycomb was embedded in the exhaust gas inlet side of the insulator honeycomb was also produced (Example 4: see FIG. 6).

As a main body of the plasma processing apparatus, a cylindrical body (the housing area was made of stainless steel) was used. The linear electrode (discharge electrode), the conductor honeycomb, and the insulator honeycomb were disposed inside the cylindrical body.

(Pulse power supply)

As a pulse power supply, a high-voltage pulse power supply that utilizes an SI thyristor (manufactured by NGK Insulators, Ltd.) was used. The pulse power supply was electrically connected to the linear electrode (positive electrode) and the conductor honeycomb (negative electrode). A pulse voltage was applied between the linear electrode and the conductor honeycomb from the pulse power supply in a cycle of 3 kHz.

(FTP test) A manifold system (MF) shown in FIG. 8 was formed. In the manifold system, 0.9 1 of a light-off catalyst was disposed on the upstream side, and 1.7 1 of a main catalyst was disposed on the downstream side. The manifold system included an engine 21, s plasma processing apparatus 1, a light-off catalyst 22, and a main catalyst 23 in this order from the upstream side. As the engine 21, an L4 engine (displacement: 2000 cc) was used.

The Bag emission was measured in accordance with the Federal Test Procedure (FTP) under conditions shown in Table 1 to evaluate the cold start characteristics of the examples and comparative examples.

**TABLE 1**

| | Reactor / presence or absence of catalyst | System | Amount of power supplied (kW) | FTP performance (HC emission) Bag (g) ^{*2} |
|---|---|---|---|---|
| Example 1 | Reactor 1 / plasma was used, catalyst was not used | MF^{*1} | 0.1 | 1.24 |
| Example 2 | Reactor 2 / plasma was used, catalyst was not used | MF | 0.1 | 0.98 |
| Example 3 | Reactor 3 / plasma was used, catalyst was not used | MF | 0.1 | 0.65 |
| Example 4 | Reactor 4 / plasma was used, catalyst was not used | MF | 0.1 | 0.46 |
| Example 5 | Reactor 2 / plasma was used, catalyst was used | MF | 0.1 | 0.53 |
| Example 6 | Reactor 3 / plasma was used, catalyst was used | MF | 0.1 | 0.28 |
| Comparative Example 1 | Reactor was not used / plasma was not used | MF | 0.0 | 1.54 |
| Comparative Example 2 | Reactor 2 / plasma was not used, catalyst was not used | MF | 0.0 | 1.49 |

| | | | | |
|---|---|---|---|---|
| ^{*1} MF: manifold system (see FIG. 8) ^{*2} Bag: Amount of HC discharged within 140 seconds after starting the engine | | | | |

As is clear from the comparison between the FTP performance (HC emission) of Example 1 and the FTP performance of Example 2, it is preferable that the conductor honeycomb be in contact with the insulator honeycomb in order to effectively activate the catalyst supported on the insulator honeycomb.

Example 2 and Example 3 differ in only the number of linear electrodes. The HC emission was reduced in Example 3 as compared with Example 2. This is considered to be because the plasma generation area was increased by disposing a plurality of linear electrodes although the amount of power supplied to one linear electrode decreased. Therefore, it is preferable to dispose a plurality of linear electrodes.

Example 2 and Example 4 differ in the installation position of the conductor honeycomb. The HC emission was reduced in Example 4 as compared with Example 2. This is considered to be because heat generated by the conductor honeycomb was easily transmitted to the insulator honeycomb so that activation of the catalyst was further promoted.

As is clear from the comparison between the FTP performance of Examples 1 to 6 and the FTP performance of Comparative Example 1, the HC emission was reduced in Examples 1 to 6 as compared with Comparative Example 1. Specifically, the present invention is effective to reduce exhaust gas during startup (cold start) of an engine.

Example 2 and Comparative Example 2 demonstrate the effect of plasma (catalyst was not used). It is obvious that the HC emission cannot be reduced by merely disposing the conductor honeycomb to come in contact with the insulator honeycomb.

The plasma processing apparatus according to the present invention can be used as an exhaust gas purification system that effectively purifies toxic substances (e.g., hydrocarbon (HC), carbon monoxide (CO), and nitrogen oxide (NOx); particularly HC that are produced in large quantities) discharged from an internal combustion engine during startup (cold start).

## Claims

1. A plasma processing apparatus comprising a main body that has an inlet for a purification target gas and an outlet for a purified gas, an insulator honeycomb that includes a plurality of cells that are partitioned by a partition wall and serve as gas passages and purifies the purification target gas, a catalyst being supported on the partition wall, a conductor honeycomb that is disposed to be able to transmit heat to the insulator honeycomb and includes a plurality of cells that are partitioned by a partition wall and serve as gas passages, a discharge electrode that is disposed opposite to the conductor honeycomb and forms a pair of electrodes with the conductor honeycomb, and a pulse power supply that applies a pulse voltage between the pair of electrodes to generate plasma between the pair of electrodes, the insulator honeycomb, the conductor honeycomb, and the discharge electrode being disposed in an inner space of the main body.

2. The plasma processing apparatus according to claim 1, wherein the discharge electrode, the conductor honeycomb, and the insulator honeycomb are disposed in this order from the inlet to the outlet of the main body.

3. The plasma processing apparatus according to claim 1 or 2, wherein the conductor honeycomb is disposed to physically come in contact with the insulator honeycomb.

4. The plasma processing apparatus according to any one of claims 1 to 3, wherein the conductor honeycomb is disposed to come in contact with a purification target gas inlet side of the insulator honeycomb.

5. The plasma processing apparatus according to any one of claims 1 to 3, wherein the conductor honeycomb is embedded in part of a purification target gas inlet side of the insulator honeycomb.

6. The plasma processing apparatus according to any one of claims 1 to 5, wherein the insulator honeycomb includes an insulating ceramic.

7. The plasma processing apparatus according to claim 6, wherein the insulator honeycomb includes cordierite.

8. The plasma processing apparatus according to any one of claims 1 to 7, wherein the conductor honeycomb includes a conductive ceramic.

9. The plasma processing apparatus according to claim 8, wherein the conductive ceramic includes silicon carbide.

10. The plasma processing apparatus according to any one of claims 1 to 9, wherein a catalyst is supported on the partition wall of the conductor honeycomb.

11. The plasma processing apparatus according to any one of claims 1 to 10, wherein a discharge end of the discharge electrode is a needle-like electrode or a rod-like electrode.

12. The plasma processing apparatus according to any one of claims 1 to 11, wherein a pulse half-width of the pulse power supply for generating plasma can be controlled to 1 µs or less.
